(19) Europäisches Patentamt
European Patent Office
Office européen des brevets

(11) **EP 4 268 981 A1**

(12) **EUROPEAN PATENT APPLICATION**
published in accordance with Art. 153(4) EPC

(43) Date of publication:
**01.11.2023 Bulletin 2023/44**

(21) Application number: **21910628.3**

(22) Date of filing: **17.12.2021**

(51) International Patent Classification (IPC):
**B05D 7/24** *(2006.01)*  **B32B 27/18** *(2006.01)*
**B32B 27/30** *(2006.01)*  **C08K 5/16** *(2006.01)*
**C08K 5/42** *(2006.01)*  **C08L 27/18** *(2006.01)*
**C08K 3/28** *(2006.01)*  **D06M 13/256** *(2006.01)*
**D06M 15/256** *(2006.01)*

(52) Cooperative Patent Classification (CPC):
**B05D 7/24; B32B 27/18; B32B 27/30; C08K 3/28;
C08K 5/16; C08K 5/42; C08L 27/18; D06M 13/256;
D06M 15/256**

(86) International application number:
**PCT/JP2021/046711**

(87) International publication number:
**WO 2022/138483 (30.06.2022 Gazette 2022/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.12.2020 JP 2020212228
26.03.2021 JP 2021053860**

(71) Applicant: **AGC INC.
Chiyoda-ku,
Tokyo 1008405 (JP)**

(72) Inventors:
• **TERADA, Tatsuya
  Tokyo 100-8405 (JP)**
• **NISHI, Mai
  Tokyo 100-8405 (JP)**
• **HOSODA, Tomoya
  Tokyo 100-8405 (JP)**

(74) Representative: **Müller-Boré & Partner
Patentanwälte PartG mbB
Friedenheimer Brücke 21
80639 München (DE)**

(54) **AQUEOUS DISPERSION**

(57)    To provide an aqueous dispersion containing particles of a tetrafluoroethylene-type polymer with low pH fluctuation and excellent long-term storage stability and handling efficiency.

An aqueous dispersion containing particles of a tetrafluoroethylene-type polymer, a predetermined compound such as an ammonium salt of a compound selected from the group consisting of carbonic acid, phosphoric acid, boric acid, formic acid, oxalic acid, acetic acid, citric acid and lactic acid, and water, and having a pH of at least 5 and at most 10.

EP 4 268 981 A1

**Description**

TECHNICAL FIELD

The present invention relates to an aqueous dispersion containing particles of a tetrafluoroethylene-type polymer.

BACKGROUND ART

A tetrafluoroethylene-type polymer such as polytetrafluoroethylene (PTFE) is excellent in physical properties such as electrical properties, water and oil repellency, chemical resistance and heat resistance, and is utilized in various industrial applications such as printed circuit boards. As a coating agent to be used to impart the above-mentioned properties to a substrate surface, a dispersion containing particles of a tetrafluoroethylene-type polymer is known.

Especially, in recent years, a dispersion containing particles of a tetrafluoroethylene-type polymer has attracted attention as a material excellent in electrical properties and insulation performance, such as low dielectric constant and low dielectric loss tangent, for forming a dielectric layer on a printed circuit board corresponding to a frequency in a high frequency band.

Since the dispersion stability of particles of a tetrafluoroethylene-type polymer is remarkably low, various proposals have been made in the past from the viewpoint of obtaining a dispersion excellent in dispersion stability. Patent Document 1 discloses an aqueous dispersion of tetrafluoroethylene-type polymer particles containing a water-soluble thickening agent, a nonionic surfactant with a weight average molecular weight of less than 100,000, and an amine as a pH adjuster and having a pH of at least 8.5, for application to a composite plating solution, which is said to be able to suppress lowering of the dispersibility or to prevent corrosion of the substrate by avoiding acidic regions.

Patent Document 2 discloses an aqueous polytetrafluoroethylene dispersion containing a dispersing agent and having a pH of from 8 to 13, and one containing an amine or sodium hydroxide as a pH adjuster, is disclosed.

Patent Document 3 discloses an aqueous dispersion containing PTFE, an organic electrolyte such as citric acid, and a specific surfactant, and it is stated that the pH is adjusted by adding ammonia water to suppress pH decrease.

PRIOR ART DOCUMENTS

PATENT DOCUMENTS

Patent Document 1: JP-A-2019-052211
Patent Document 2: JP-A-2019-182956
Patent Document 3: JP-A-2012-214766

DISCLOSURE OF INVENTION

TECHNICAL PROBLEM

The aqueous dispersion itself containing particles of a tetrafluoroethylene-type polymer is generally acidic to neutral, and is therefore prone to mold and algae growth, and to bacterial growth and decomposition. For this reason, in the above-mentioned Patent Documents 1, 2 and 3, an amine or the like is added. However, the present inventors have found problems in handling efficiency in that an aqueous dispersion containing particles of a tetrafluoroethylene-type polymer may fluctuate in pH with the passage of days, resulting in the transformation of the particles, degradation of liquid properties such as dispersibility of the aqueous dispersion, and labor to check and readjust the pH when to be used.

As a result of their diligent study, the present inventors have found that an aqueous dispersion containing particles of a tetrafluoroethylene-type polymer, a predetermined compound which contributes to pH stabilization, and water, is excellent in dispersion stability and excellent in long-term storage stability and handling efficiency, that it is possible to stabilize the pH in a predetermined range, that the tetrafluoroethylene-type polymer tends to be less susceptible to change, and that a product (such as a polymer layer) to be formed from such an aqueous dispersion is excellent in the hue.

The purpose of the present invention is to provide an aqueous dispersion containing particles of a tetrafluoroethylene-type polymer, excellent in dispersibility, with low pH fluctuation, and excellent in long-term storage stability and handling efficiency.

SOLUTION TO PROBLEM

The present invention has the following embodiments.

<1> An aqueous dispersion containing particles of a tetrafluoroethylene-type polymer, at least one compound selected from the following groups of compounds (1), (2) and (3), and water, with a pH of at least 5 and at most 10:

(1) 2-morpholinoethanesulfonic acid, bis(2-hydroxyethyl)iminotris(hydroxymethyl)methane, N-(2-acetamido)-2-aminoethanesulfonic acid, 2-hydroxy-3-morpholinopropanesulfonic acid, 2-hydroxy-N-tris(hydroxymethyl)methyl-3-aminopropanoic acid, N-tris(hydroxymethyl)methyl-3-aminopropanoic acid, N,N-bis(2-hydroxyethyl)-2-aminoethanesulfonic acid, 3-morpholinopropanesulfonic acid, N-tris(hydroxymethyl)methyl-2-aminoethanesulfonic acid, 4-(2-hydroxyethyl)-1-piperazine ethanesulfonic acid, 4-(2-hydroxyethyl)-1-piperazine propanesulfonic acid, N-[tris(hydroxymethyl)methyl]glycine, tris(hydroxymethyl)aminomethane, N,N-bis(2-hydroxyethyl)glycine, glycylglycine, N-cyclohexyl-2-aminoethanesulfonic acid, N-cyclohexyl-3-aminopropanesulfonic acid and ethylenediaminetetraacetic acid,
(2) salts of the compounds in the above (1),
(3) an ammonium salt of any of the following acids: carbonic acid, phosphoric acid, boric acid, formic acid, oxalic acid, acetic acid, citric acid and lactic acid

<2> The aqueous dispersion according to <1>, wherein the tetrafluoroethylene-type polymer is a tetrafluoroethylene-type polymer with a fluorine atom content of at least 70 mass% and a melting temperature of from 200 to 320°C.
<3> The aqueous dispersion according to <1> or <2>, wherein the tetrafluoroethylene-type polymer is a tetrafluoroethylene-type polymer which contains units based on a perfluoro(alkyl vinyl ether) and which has oxygen-containing polar groups.
<4> The aqueous dispersion according to any one of <1> to <3>, wherein the average particle diameter (cumulative 50% diameter on a volume basis) of the particles of the tetrafluoroethylene-type polymer is from 0.1 to 25 μm.
<5> The aqueous dispersion according to any one of <1> to <4>, wherein the particles of the tetrafluoroethylene-type polymer include particles of polytetrafluoroethylene and particles of a tetrafluoroethylene-type polymer with a melting temperature of from 200 to 320°C.
<6> The aqueous dispersion according to any one of <1> to <5>, which further contains a nonionic surfactant.
<7> The aqueous dispersion according to <6>, wherein the nonionic surfactant is a polyoxyalkylene-modified polydimethylsiloxane having a weight average molecular weight of at most 3,000 and an HLB value calculated from the Griffin formula of from 1 to 18.
<8> The aqueous dispersion according to any one of <1> to <7>, wherein the content of the at least one compound is from 0.01 to 5 mass% to the total mass of the aqueous dispersion.
<9> The aqueous dispersion according to any one of <1> to <8>, wherein the salts of the compounds in the above (1) are in the form of hydrochloric acid salts, ammonium salts or organic acid salts.
<10> The aqueous dispersion according to any one of <1> to <9>, wherein the at least one compound is an ammonium salt of a compound selected from the group consisting of carbonic acid, phosphoric acid, boric acid, formic acid, oxalic acid, acetic acid, citric acid and lactic acid.
<11> The aqueous dispersion according to <10>, wherein the at least one compound is ammonium formate, ammonium oxalate, ammonium acetate, triammonium citrate, diammonium hydrogen phosphate, triammonium phosphate, ammonium borate, ammonium hydrogen carbonate, or ammonium carbonate.
<12> The aqueous dispersion according to any one of <1> to <11>, wherein the at least one compound is ammonium bicarbonate, ammonium carbonate or ammonium acetate.
<13> The aqueous dispersion according to any one of <1> to <12>, wherein the range of pH fluctuation after storage at 25°C for 30 days is within ±1.
<14> A method for producing a laminate, which comprises applying the aqueous dispersion as defined in any one of <1> to <13> to the surface of a substrate, followed by heating to form a polymer layer containing the tetrafluoroethylene-type polymer, to obtain a laminate having a substrate layer consisting of the substrate and the polymer layer.
<15> A method for producing an impregnated woven fabric, which comprises impregnating the aqueous dispersion as defined in any one of <1> to <13> to a woven fabric, followed by heating to obtain an impregnated woven fabric containing the tetrafluoroethylene-type polymer.

ADVANTAGEOUS EFFECTS OF INVENTION

According to the present invention, it is possible to provide an aqueous dispersion containing particles of a tetrafluoroethylene-type polymer with low pH fluctuation and excellent in long-term storage stability and handling efficiency. A molded product obtainable from the aqueous dispersion of the present invention is excellent in physical properties such as electrical properties as well as in its hue, and is useful, for example, as a component material of printed circuit boards.

DESCRIPTION OF EMBODIMENTS

The following terms have the following meanings.

The "average particle diameter (D50)" is the cumulative 50% diameter of the object (particles) on a volume basis, as determined by the laser diffraction and scattering method. That is, the particle size distribution is measured by the laser diffraction and scattering method, the cumulative curve is obtained by taking the total volume of the particle population as 100%, and the particle diameter is the particle diameter at the point on the cumulative curve where the cumulative volume becomes 50%.

D50 of an object is obtained by dispersing the particles in water and analyzing them by the laser diffraction and scattering method by using a laser diffraction and scattering particle size analyzer (LA-920 instrument manufactured by HORIBA, Ltd.).

The "melting temperature" is the temperature corresponding to the maximum value of the melting peak of the polymer as measured by the differential scanning calorimetry (DSC).

The "viscosity of the dispersion" is a viscosity measured by using a Type B viscometer under conditions at 25°C at a rotation speed of 30 rpm. The measurement is repeated three times, and the average of the three measurements is adopted.

The "thixotropic ratio" is a value calculated by dividing the viscosity of the dispersion, $\eta_1$, measured at a rotational speed of 30 rpm, by the viscosity, $\eta_2$, measured at a rotational speed of 60 rpm. Each viscosity measurement is repeated three times, and the average of the three measurements is adopted.

The "weight average molecular weight of polyoxyalkylene-modified polydimethylsiloxane" is obtained as the weight average molecular weight in polystyrene equivalent in gel permeation chromatography (GPC) analysis.

The "HLB value of polyoxyalkylene-modified polydimethylsiloxane" is a value calculated by the Griffin formula, and is obtained by dividing the molecular weight of the polyoxyalkylene portion in the molecule by the molecular weight of the organopolysiloxane and multiplying the obtained value by 20.

The "static surface tension" is obtained by using an automatic surface tension meter CBVP-Z type (manufactured by Kyowa Interface Science Co., Ltd.) by the Wilhelmy's method and using a 0.1 mass% aqueous solution of polyoxyalkylene-modified polydimethylsiloxane.

The "dynamic surface tension" is the dynamic surface tension of a 0.1 mass% aqueous solution of polyoxyalkylene-modified polydimethylsiloxane at 25°C with a bubble generation period of 6 Hz using the maximum bubble pressure method. It is a value obtained by measuring the dynamic surface tension of an aqueous solution containing polyoxyalkylene-modified polydimethylsiloxane in a proportion of 0.1 mass% by the maximum bubble pressure method by immersing the sensor of a dynamic surface tension meter Theta t60 manufactured by EKO INSTRUMENTS CO., LTD. in an environment at a temperature of 25°C. The measurement is carried out by setting the bubble generation period of the aqueous solution to be 6 Hz.

A "unit" in a polymer means an atomic group based on a monomer formed by polymerization of the monomer. The unit may be a unit formed directly by the polymerization reaction, or it may be a unit in which a part of the unit is converted to another structure by treating the polymer. Hereafter, units based on monomer a are simply referred to also as "monomer a units".

The aqueous dispersion of the present invention (hereinafter referred to also as "the present dispersion") contains particles (hereinafter referred to also as "F powder") of a tetrafluoroethylene-type polymer (hereinafter referred to also as "F polymer"), a specific compound as described below, and water, and the pH is at least 5 and at most 10.

The present dispersion has low pH fluctuation and is excellent in long-term storage stability and handling efficiency. Further, the molded product (fired product) to be formed from the present dispersion is excellent in physical properties based on the F polymer, such as electrical properties, as well as excellent in surface smoothness and hue.

The reasons and action mechanism for the improvement of the long-term storage stability of the present dispersion are not necessarily clear, but are estimated, for example, as follows.

The F polymer has a remarkably low surface tension and low affinity with water. Therefore, in water, the F polymer is not only in a state where it is likely to form complex secondary particles and easily agglomerated, but also in a state where the F polymer or particles themselves are likely to be modified. Even if the particles of the F polymer in the dispersion are stably dispersed due to the effect of prescribed additive components such as dispersants, once such an effect is impaired due to pH fluctuation, the agglomeration of the F polymer particles and the modification of the F polymer itself will rapidly progress.

Therefore, the present dispersion contains a specific compound described below as an ingredient which stabilizes the pH of the dispersion in a predetermined range. The specific compound described below not only has a strong pH buffering effect, especially in the neutral to alkaline range, but also acts in the present dispersion as a dispersing agent for the F polymer and a viscosity adjuster of the dispersion, and thus is thought to improve the liquid properties of the present dispersion. Further, when a molded product (fired product) is to be formed from the present dispersion, it is less likely to remain in the molded product. As a result, it is considered possible that the present dispersion has a high level of the physical properties of the F polymer and is excellent in dispersion stability and long-term storage stability, and that the hue of the molded product (polymer layer, etc.) to be formed from such an aqueous dispersion is also excellent.

The F polymer in the present dispersion is a polymer containing units (TFE units) based on tetrafluoroethylene (TFE). The F polymer may be thermally meltable or non-thermally meltable, but is preferably thermally meltable. Here, thermal meltability means a melt flowable polymer wherein there exists a temperature at which the melt flow rate becomes to be from 0.1 to 1,000 g/10 minutes under a condition of a load of 49 N and at a temperature higher by at least 20°C than the melting temperature of the polymer.

When the F polymer is thermally meltable, the melting temperature is preferably from 200 to 320°C, more preferably from 260 to 320°C. Such a thermally meltable F polymer has conformation with a high degree of freedom, having restrictions on molecular motion relaxed at the single-molecule level, whereby the above-described effects of the present invention are likely to be expressed at a high level.

The fluorine atom content in the F polymer is preferably at least 70 mass% and more preferably from 70 to 76 mass%. A powder of an F polymer with such a high fluorine atom content is susceptible to be modified by receiving an influence due to the pH fluctuations, but by the above-mentioned effects of the present invention, it will be particularly easy to suppress such susceptibility.

The glass transition point of the F polymer is preferably from 75 to 125°C and more preferably from 80 to 100°C.

As the F polymer, polytetrafluoroethylene (PTFE), a polymer (ETFE) containing TFE units and units based on ethylene, a polymer (PFA) containing TFE units and units (PAVE units) based on perfluoro(alkyl vinyl ether) (PAVE), and a polymer (FEP) containing TFE units and units based on hexafluoropropene (HFP), may be mentioned. Each of ETFE, PFA and FEP may additionally contain other units. As PAVE, $CF_2=CFOCF_3$, $CF_2=CFOCF_2CF_3$ and $CF_2=CFOCF_2CF_2CF_3$ (PPVE) are preferred, and PPVE is more preferred.

The F polymer is preferably PFA or FEP, and PFA is more preferred.

The F polymer preferably has oxygen-containing polar groups. In such a case, it tends to be easier to form microsphere crystals at the molecular aggregate level, whereby the wettability of the F powder will be improved, and the above-described effects of the present invention tend to be expressed at a high level. Further, the present dispersion in such a case is susceptible to an influence due to pH fluctuations, but by the above-described effects of the present invention, such susceptibility tends to be particularly suppressed. As a result, a fired product (such as a polymer layer) obtainable from the present dispersion in such a case is likely to be more excellent in the physical properties such as adhesiveness, electrical properties and surface smoothness.

Oxygen-containing polar groups may be contained in units in the F polymer or in the terminal groups of the main chain of the F polymer. As the latter embodiments, an F polymer having oxygen-containing polar groups as terminal groups derived from e.g. a polymerization initiator, a chain transfer agent, etc., and an F polymer having oxygen-containing polar groups obtained by plasma treatment or ionizing ray treatment of an F polymer, may be mentioned. As the oxygen-containing polar groups, hydroxy group-containing groups, carbonyl group-containing groups and phosphono group-containing groups are preferred, and from the viewpoint of dispersion stability of the present dispersion, hydroxy group-containing groups and carbonyl group-containing groups are more preferred, and carbonyl group-containing groups are further preferred.

As the hydroxy group-containing group, a group containing an alcoholic hydroxy group is preferred, and $-CF_2CH_2OH$, $-C(CF_3)_2OH$ and 1,2-glycol group ($-CH(OH)CH_2OH$) are more preferred.

The carbonyl group-containing group is a group containing a carbonyl group ($>C(O)$), and a carboxy group, an alkoxycarbonyl group, an amide group, an isocyanate group, a carbamate group ($-OC(O)NH_2$), an acid anhydride residue ($-C(O)OC(O)-$), an imide residue (such as $-C(O)NHC(O)-$) and a carbonate group ($-OC(O)O-$) are preferred, and an acid anhydride residue is more preferred.

When the F polymer has carbonyl group-containing groups, the number of carbonyl group-containing groups in the F polymer is preferably from 10 to 5,000, more preferably from 100 to 3,000, further preferably from 800 to 1,500, per $1\times10^6$ carbon atoms in the main chain. Here, the number of carbonyl group-containing groups in the F polymer can be quantified by the composition of the polymer or by the method described in WO2020/145133.

The F polymer is preferably a polymer containing TFE units and PAVE units, and having oxygen-containing polar groups, more preferably a polymer containing TFE units, PAVE units and units based on a monomer having an oxygen-containing polar group, and further preferably a polymer containing these units, in this order, from 90 to 99 mol%, from 0.5 to 9.97 mol% and from 0.01 to 3 mol%, to all units. The presence of oxygen-containing polar groups is preferred from the viewpoint of further improving affinity and adhesion.

Here, as the monomer having an oxygen-containing polar group, itaconic anhydride, citraconic anhydride, or 5-norbornene-2,3-dicarboxylic anhydride (hereinafter referred to also as "NAH") is preferred.

As specific examples of such a polymer, polymers disclosed in WO2018/16644 may be mentioned.

In the present dispersion, D50 of the F powder is preferably from 0.1 to 25 μm. D50 of the F powder is preferably at most 20 μm, more preferably at most 10 μm, and further preferably at most 8 μm. D50 of the F powder is preferably at least 0.3 μm. With D50 in this range, the flowability and dispersibility of the F powder are likely to be good.

From the viewpoint of dispersion stability of the present dispersion, the bulk density of the F powder is preferably at least 0.15 g/m$^2$ and more preferably at least 0.20 g/m$^2$. The bulk density of the F powder is preferably at most 0.50 g/m$^2$ and more preferably at most 0.35 g/m$^2$.

Further, the specific surface area of the F powder is preferably from 1 to 8 m$^2$/g and more preferably from 1 to 3 m$^2$/g.

As the F powder, one type may be used alone, or two or more types may be used. When two types of the F powder are to be used, it is preferred to contain particles of PTFE and particles of the F polymer (suitably the above-described polymer containing TFE units and PAVE units and having oxygen-containing polar groups) whose melting temperature is from 200 to 320°C. And, it is more preferred that the mass of particles of the former is greater than the mass of particles of the latter.

In this case, the ratio of the latter particles to the sum of the former particles and the latter particles is preferably at most 25 mass% and more preferably at most 15 mass%. Further, the ratio in this case is preferably at least 0.1 mass% and more preferably at least 1 mass%.

Such a dispersion not only tends to be excellent in dispersion stability, handling efficiency and long-term storage stability, but also tends to form an adhesive molded product excellent in the physical properties based on PTFE.

Further, in this case, an embodiment in which D50 of the particles of PTFE is from 0.1 to 1 μm, and D50 of the particles of the F polymer with a melting temperature of from 200 to 320°C is from 0.1 to 1 μm, or an embodiment in which D50 of the particles of PTFE is 0.1 to 1 μm, and D50 of the particles of the F polymer with a melting temperature of from 200 to 320°C is from 1 to 4 μm, is preferred.

The F powder may contain a resin or an inorganic filler other than the F polymer, but preferably contains the F polymer as the main component. The content of the F polymer in the F powder is preferably at least 80 mass%, more preferably 100 mass%.

As the above resin, a heat-resistant resin such as an aromatic polyester, a polyamideimide, a (thermoplastic) polyimide, a polyphenylene ether, polyphenylene oxide or maleimide, may be mentioned. As the inorganic filler, silicon oxide (silica), a metal oxide (beryllium oxide, cerium oxide, alumina, soda alumina, magnesium oxide, zinc oxide, titanium oxide, etc.), boron nitride or magnesium metasilicate (steatite) may be mentioned. The inorganic filler may have at least a portion of its surface surface-treated.

The F powder containing a resin or an inorganic filler other than the F polymer may have a core-shell structure having the F polymer as the core and having a resin or an inorganic filler other than the F polymer as the shell, or a core-shell structure having the F polymer as the shell and having a resin or an inorganic filler other than the F polymer as the core. Such an F powder is obtainable, for example, by coalescence (collision, agglomeration, etc.) of a powder of the F polymer and a powder of a resin or an inorganic filler other than the F polymer.

The present dispersion is an aqueous dispersion containing the F powder, at least one compound (hereinafter referred to also as a "buffer") selected from the following groups of compounds (1), (2) and (3) and water, and having a pH of at least 5 and at most 10:

(1) 2-morpholinoethanesulfonic acid, bis(2-hydroxyethyl)iminotris(hydroxymethyl)methane, N-(2-acetamido)-2-aminoethanesulfonic acid, 2-hydroxy-3-morpholinopropanesulfonic acid, 2-hydroxy-N-tris(hydroxymethyl)methyl-3-aminopropanoic acid, N-tris(hydroxymethyl)methyl-3-aminopropanoic acid, N,N-bis(2-hydroxyethyl)-2-aminoethanesulfonic acid, 3-morpholinopropanesulfonic acid, N-tris(hydroxymethyl)methyl-2-aminoethanesulfonic acid, 4-(2-hydroxyethyl)-1-piperazineethanesulfonic acid, 4-(2-hydroxyethyl)-1-piperazine propanesulfonic acid, N-[tris(hydroxymethyl)methyl]glycine, tris(hydroxymethyl)aminomethane, N,N-bis(2-hydroxyethyl)glycine, glycylglycine, N-cyclohexyl-2-aminoethanesulfonic acid, N-cyclohexyl-3-aminopropanesulfonic acid and ethylenediaminetetraacetic acid,
(2) salts of the compounds in the above (1),
(3) an ammonium salt of any of the following acids: carbonic acid, phosphoric acid, boric acid, formic acid, oxalic acid, acetic acid, citric acid and lactic acid.

The above buffer (1) or (2) contains a functional group containing a heteroatom such as a nitrogen atom, an oxygen atom and a sulfur atom, and can be considered as a group of compounds belonging to the category of amphoteric ionic compounds.

The above buffer (1) or (2) is also a compound that constitutes a buffer liquid to be used depending on the pH range to control pH fluctuations within a system, in the field of biochemistry, for example, in enzyme activity measurement in enzymatic catalytic reactions, in experimental systems that simulate in vivo reactions such as cell culture or washing of cultured cells, or in tests that handle proteins or nucleic acids such as genetic recombination experiments.

In particular, some of the above buffers (1) and (2) are also compounds that belong to the category of buffers called Good's Buffer, which are to be used in the field of biochemistry.

For example, in the case of (2), where the buffer is in the form of a salt of the compound in (1), it is preferred that the buffer be in a form other than a metal salt, and it is more preferred that it be in the form of a hydrochloride salt, an ammonium salt, or an organic acid salt, and it is further preferred that it be an ammonium salt or an organic acid salt, and it is particularly preferred that it be an ammonium salt. The form of the ammonium salt may be an ammonium ion or a quaternary ammonium salt (tetramethylammonium salt, tetraethylammonium salt, tetrapropylammonium salt, benzyltrimethylammonium salt, etc.). As the organic acid salt, a formate, an acetate, a maleate and a phthalate may be mentioned. When the aforementioned buffer is used in the form of a salt, it is considered that the salt state and the free compound are in a state of chemical equilibrium in the present dispersion to form a system having a buffering effect.

When the buffer is in the form of an ammonium salt or an organic acid salt, especially in the form of an ammonium salt, it is possible to suppress salt-derived components remaining in the molded product (F layer) obtainable by firing the present dispersion after applying it to e.g. a substrate, and to suppress decomposition and coloration of the F polymer in the molded product (F layer). Further, it is easy to improve the physical properties of the molded product.

The buffer is preferably an ammonium salt of at least one compound selected from the group consisting of carbonic acid, phosphoric acid, boric acid, formic acid, oxalic acid, acetic acid, citric acid and lactic acid and more preferably an ammonium salt of at least one compound selected from the group consisting of carbonic acid, phosphoric acid, boric acid, formic acid, acetic acid, citric acid and lactic acid. In such a case, the present dispersion is more likely to be excellent in dispersion stability and long-term storability. Further, it is possible to suppress residual buffer-derived components in the molded product (F layer) obtainable by firing the present dispersion after applying it to e.g. a substrate, and to suppress decomposition of the F polymer in the molded product (F layer) and to improve the physical properties of the molded product.

The buffer is preferably an ammonium salt of carbonic acid, an ammonium salt of phosphoric acid or an ammonium salt of boric acid, and more preferably an ammonium salt of carbonic acid. In such a case, it is easier to control the change in hue of the present dispersion, and when forming a molded product (fired product) from the present dispersion, the buffer is less likely to remain in the molded product. As the ammonium salt of carbonic acid, ammonium bicarbonate salt or ammonium carbonate salt is preferred, and ammonium bicarbonate salt is more preferred.

The form of the ammonium salt may be an ammonium ion or a quaternary ammonium salt (tetramethylammonium salt, tetraethylammonium salt, tetrapropylammonium salt, benzyltrimethylammonium salt, etc.). Among them, an ammonium ion is preferred from the viewpoint of stability in the present dispersion, specifically, from the viewpoint of difficulty in evaporation and oxidation during storage of the present dispersion, and from the viewpoint of suppressing changes in the hue of the present dispersion, and from the viewpoint of difficulty in remaining in the molded product (fired product) when forming a molded product (fired product) from the present dispersion.

As specific examples of the buffer, ammonium formate (6.4), ammonium oxalate (6.8), ammonium acetate (6.5), triammonium citrate (7.4), diammonium hydrogen phosphate (8.1), triammonium phosphate (9.4), ammonium borate (8.3), ammonium bicarbonate (8.1) and ammonium carbonate (9.1) may be mentioned. The numbers in parentheses for the respective compounds indicate the approximate pH buffer range.

When these are used, it is possible to suppress residual buffer-derived components in the molded product (F layer) obtainable by firing the present dispersion after applying it to e.g. a substrate, and to suppress decomposition of the F polymer in the molded product (F layer) and to improve the physical properties of the molded product and the hue of the molded product.

Among them, diammonium hydrogen phosphate, triammonium phosphate, ammonium borate, ammonium bicarbonate, and ammonium carbonate are preferred, and ammonium bicarbonate is more preferred.

The content of the buffer is preferably from 0.01 to 5 mass% to the mass of the entire present dispersion. The above content of the buffer is preferably at least 0.05 mass%, more preferably at least 0.1 mass%, and preferably at most 4 mass%, more preferably at most 3 mass% to the mass of the entire present dispersion.

When the content of the buffer is within such a range, the pH of the present dispersion can be appropriately controlled to be at least 5 and at most 10, and yet it is possible to make the fluctuation range of the pH of the present dispersion to be small during the long-term storage. As a result, it is possible to obtain the present dispersion excellent in long-term storage stability and handling efficiency.

The content of water in the present dispersion is preferably at least 40 mass% and more preferably at least 50 mass%. The content of water is preferably at most 90 mass% and more preferably at most 80 mass%. In such a range, the dispersion stability of the present dispersion is more easily improved.

The present dispersion may further contain a water-soluble dispersant other than water as a dispersant. As such a water-soluble dispersant, a water-soluble compound which is liquid at 25°C and is classified as polar under atmospheric pressure, is preferred, and, for example, N,N-dimethylformamide, N,N-dimethylacetamide, 3-methoxy-N,N-dimethylpropanamide, 3-butoxy-N,N-dimethylpropanamide, or N-methyl-2-pyrrolidone, may be mentioned.

The present dispersion can be prepared by mixing the F powder, a buffer and water as a dispersant. As the mixing method, a method of adding the F powder and the buffer to water all at once or sequentially; a method of mixing while adding the F powder to a mixture of water and the buffer; a method of pre-mixing the F powder and water, and the buffer and water, respectively, and further mixing the obtained mixture of the two; or the like, may be mentioned.

Mixing methods for preparing the present dispersion include, for example, stirring by an agitator equipped with single or multi-axis blades such as propeller blades, turbine blades, paddle blades and shell-shaped blades, as well as a Henschel mixer, a pressure kneader, a Banbury mixer or a planetary mixer; mixing by a dispersing machine using media such as ball mills, attritors, basket mills, sand mills, sand grinders, dyno mills (bead mills using grinding media such as glass beads or zirconium oxide beads), disperser mats, SC mills, spike mills, or agitator mills; and mixing by using a dispersing machine which does not use media, including a high-pressure homogenizer such as a microfluidizer, a nanomizer or an ultimizer, an ultrasonic homogenizer, a dissolver, a disperser, a high-speed impeller disperser, a spinning and revolving agitator, a thin-film swirling high-speed mixer, or the like.

The present dispersion may further contain a surfactant. When the present dispersion contains a surfactant, it is preferred that the surfactant is nonionic, and the hydrophobic moiety of the surfactant preferably has an acetylene group or polysiloxane group, and the hydrophilic moiety preferably has an oxyalkylene group or alcoholic hydroxy group.

That is, when the present dispersion further contains a surfactant, a nonionic surfactant is preferred, and a polyoxyalkylene alkyl ether, an acetylene type surfactant or a silicone type surfactant is more preferred. These surfactants preferably have an alcoholic hydroxy group. One type of these surfactants may be used alone, or two or more types may be used in combination. From the viewpoint that the polyoxyalkylene alkyl ether stabilizes the long-term dispersibility of the F powder and improves liquid properties such as viscosity of the present dispersion, and from the viewpoint that the silicone surfactant improves the initial dispersibility of the F powder, it is preferred to use the polyoxyalkylene alkyl ether and the silicone type surfactant in combination.

When the present dispersion further contains a surfactant, the amount of the surfactant is preferably from 1 to 15 mass% to the mass of the entire present dispersion. In such a case, the affinity between the components is enhanced, and the dispersion stability of the present dispersion is likely to be more improved.

The silicone type surfactant is preferably a polyoxyalkylene-modified polydimethylsiloxane having a weight average molecular weight of at most 3,000 and an HLB value of from 1 to 18, as calculated from the Griffin formula, from the viewpoint of suppressing the load to the environment and from the viewpoint of the stability in the present dispersion.

The above-mentioned polyoxyalkylene-modified polydimethylsiloxane (hereinafter referred to also as the "modified polydimethylsiloxane") is an organopolysiloxane having a polyoxyalkylene structure as a hydrophilic group and a polydimethylsiloxane structure as a hydrophobic group, and is preferably a linear polymer.

The weight average molecular weight of the modified polydimethylsiloxane is at most 3,000, preferably at most 2,500 and more preferably at most 2,000. The weight average molecular weight is preferably at least 100 and more preferably at least 500.

The number average molecular weight of the modified polydimethylsiloxane is preferably at most 3,000 and more preferably at most 1,500. The number average molecular weight is preferably at least 100 and more preferably at least 500.

The molecular weight dispersibility of the modified polydimethylsiloxane is preferably less than 2.0 and more preferably at most 1.8. The lower limit of the molecular weight dispersibility is preferably more than 1.0.

The HLB value of the modified polydimethylsiloxane is from 1 to 18, preferably at least 3, more preferably at least 6, further preferably at least 10 and particularly preferably at least 12. The HLB value is preferably at most 16 and more preferably at most 15.

The static surface tension of the modified polydimethylsiloxane is preferably at most 28 mN/m and more preferably at most 26 mN/m. The static surface tension is preferably at least 15 mN/m and more preferably at least 20 mN/m.

The dynamic surface tension of the modified polydimethylsiloxane is preferably at most 40 mN/m and more preferably at most 35 mN/m, and the dynamic surface tension is preferably at least 20 mN/m.

The modified polydimethylsiloxane may have dimethylsiloxane units ($-(CH_3)_2 SiO_{2/2}-$) in the main chain, may have dimethylsiloxane units in the side chains, or may have dimethylsiloxane units in both the main and side chains.

The modified polydimethylsiloxane is preferably a modified polydimethylsiloxane containing dimethylsiloxane units in the main chain and oxyalkylene groups in the side chains, or a modified polydimethylsiloxane containing dimethylsiloxane units in the main chain and oxyalkylene groups at the main chain terminals.

As specific examples of the polyoxyalkylene-modified polydimethylsiloxane, BYK-347, BYK-349, BYK-378, BYK-3450, BYK-3451, BYK-3455 and BYK-3456 (manufactured by BYK Japan K.K.), and KF-6011 and KF-6043 (manufactured by Shin-Etsu Chemical Co. Ltd.), may be mentioned.

The above-mentioned polyoxyalkylene-modified polydimethylsiloxane, which has such a small weight average molecular weight and an HLB value within a predetermined range, may be said to be a silicone type surfactant having its hydrophobic and hydrophilic properties highly balanced. That is, from such a viewpoint that its polymer chain length is short, and it is easy to cover the surface of the F powder, it is thought that its interaction with the F powder is enhanced and it adheres to the F powder to a high degree, whereby it is easy to improve the dispersion stability of the F powder.

Further, the above-described modified dimethylsiloxane is excellent in thermal degradability, whereby it is easily decomposed when the present dispersion is heated to form a fired product. As a result, the fired product is likely to have a high degree of physical properties based on the F polymer.

The polyoxyalkylene alkyl ether is preferably polyoxyethylene decyl ether, polyoxyethylene undecyl ether, polyoxyethylene dodecyl ether, polyoxyethylene tridecyl ether, polyoxyethylene tetradecyl ether, triethylene glycol monomethyl ether, polyethylene glycol trimethyl nonyl ether, ethylene glycol mono-2-ethylhexyl ether, diethylene glycol monomethyl ether, diethylene glycol monoethyl ether, diethylene glycol monobutyl ether, dipropylene glycol monobutyl ether, triethylene glycol monomethyl ether, diethylene glycol monoethyl ether acetate or diethylene glycol monobutyl ether acetate, and more preferably polyoxyethylene decyl ether, polyoxyethylene undecyl ether, polyoxyethylene dodecyl ether, polyoxyethylene tridecyl ether or polyoxyethylene tetradecyl ether.

The polyoxyalkylene alkyl ethers are available as commercial products, and specifically, Tergitol TMN-100X (manufactured by Dow Chemical), Lutensol TO8, Lutensol XL70, Lutensol XL80, Lutensol XL90, Lutensol XP80, Lutensol M5 (manufactured by BASF), Newcol 1305, Newcol 1308FA, Newcol 1310 (manufactured by NIPPON NYUKAZAI CO., LTD.), LEOCOL TDN-90-80 and LEOCOL SC-90 (manufactured by Lion Specialty Chemicals Co., Ltd.) may be mentioned.

The present dispersion may further contain at least one nonionic water-soluble polymer selected from the group consisting of polyvinyl alcohol type polymers, polyvinyl pyrrolidone type polymers and polysaccharides. In such a case, the rheological properties as well as the dispersion stability of the present dispersion are improved, and the handling properties such as film-forming properties of the present dispersion are likely to be further improved. As a result, it is easier to form a thicker molded product or a molded product of any optional shape from the present dispersion. In particular, when the water-soluble polymer has a nonionic hydroxy group, this tendency is likely to become more pronounced.

The polyvinyl alcohol type polymer may be a partially acetylated or partially acetalized polyvinyl alcohol.

As the polysaccharides, glycogens, amicropectins, dextrins, glucans, fructans, chitins, amyloses, agaroses, amicropectins, and celluloses may be mentioned. As the celluloses, methyl cellulose, ethyl cellulose, hydroxymethyl cellulose, hydroxyethyl cellulose and hydroxypropyl cellulose may be mentioned.

As the nonionic water-soluble polymers, nonionic polysaccharides are preferred, nonionic celluloses are more preferred, and hydroxymethyl cellulose, hydroxyethyl cellulose or hydroxypropyl cellulose is further preferred.

As specific examples of such nonionic polysaccharides, the SUNROSE (registered trademark) series (manufactured by Nippon Paper Industries Co., Ltd.), METROSE (registered trademark) series (manufactured by Shin-Etsu Chemical Co., Ltd.), and HEC CF grade (manufactured by Sumitomo Seika Chemicals Co., Ltd.) may be mentioned.

When the present dispersion further contains a nonionic water-soluble polymer, the amount of the nonionic water-soluble polymer is preferably at least 0.01 mass% and more preferably at least 0.1 mass%, to the mass of the entire present dispersion. Further, the amount is preferably less than 1 mass%. The ratio of the mass of the water-soluble polymer to the mass of the F powder in the present dispersion is preferably at least 0.001 and more preferably at least 0.01. Further, the ratio is preferably less than 0.1.

The present dispersion may further contain a resin material other than the F polymer from the viewpoint of improving adhesion and low linear expansion of the molded product to be formed from the present dispersion. Such a resin material may be thermosetting, thermoplastic, or modified, and may be dissolved or may be dispersed without being dissolved in the present dispersion.

As such a resin material, a tetrafluoroethylene polymer other than the F polymer, an aromatic polyimide, an aromatic polyamic acid as a precursor of an aromatic polyimide, an aromatic polyamideimide, a precursor of an aromatic polyamideimide, an aromatic maleimide, an acrylic resin, a phenolic resin, a liquid crystalline polyester, a liquid crystalline polyesteramide, a polyolefin resin, a modified polyphenylene ether, a multifunctional cyanate ester resin, a multifunctional maleimide-cyanate ester resin, a multifunctional maleimide, an aromatic elastomer such as a styrene elastomer, a vinyl ester resin, an urea resin, a diallyl phthalate resin, a melamine resin, a guanamine resin, a melamine-urea co-condensation resin, a polycarbonate, a polyarylate, a polysulfone, a polyarylsulfone, an aromatic polyamide, an aromatic polyetherimide, a polyphenylene sulfide, a polyallyl ether ketone, a polyamideimide, a polyphenylene ether, an epoxy resin, etc., may be mentioned.

When the present dispersion further contains a resin material, its content is preferably at most 40 mass% to the mass of the entire present dispersion.

As a suitable embodiment of the resin material, an aromatic polymer may be mentioned. The aromatic polymer is preferably an aromatic polyimide, an aromatic maleimide, a polyphenylene ether, an aromatic polyamic acid, an aromatic polyamideimide, a precursor of an aromatic polyamideimide or an aromatic elastomer (such as a styrene elastomer), and more preferably an aromatic polyimide, an aromatic polyamic acid, an aromatic polyamideimide, or a precursor of an aromatic polyamideimide.

In such a case, not only the adhesion and low linear expansion of the molded product to be formed from the present dispersion will be further improved, but also the liquid properties (viscosity, thixotropy ratio, etc.) of the present dispersion will be balanced, whereby it will be easier to improve its handling efficiency.

Here, as the styrene elastomer, a copolymer of styrene and a conjugated diene or (meth)acrylic ester (such as a styrene-butadiene rubber, a styrene type core/shell copolymer or a styrene type block copolymer) may be mentioned, and a styrene elastomer, which has both rubber and plastic properties and, when heated, is plasticized and exhibits flexibility, is preferred.

The present dispersion may further contain an inorganic filler. In such a case, the molded product to be formed from the present dispersion is likely to be excellent in electrical properties and low linear expansion properties.

As the inorganic filler, a nitride filler or an inorganic oxide filler is preferred, a boron nitride filler, a beryllia filler (filler of beryllium oxide), a silicate filler (silica filler, wollastonite filler, talc filler) or a metal oxide (cerium oxide, aluminum oxide, magnesium oxide, zinc oxide, titanium oxide, etc.) filler is more preferred, and silica filler is further preferred.

The inorganic filler preferably has at least part of its surface treated with a silane coupling agent (3-aminopropyltriethoxysilane, vinyltrimethoxysilane, 3-mercaptopropyltrimethoxysilane, 3-glycidoxypropylmethyldiethoxysilane, 3-methacryloxypropyltriethoxysilane, 3-isocyanatepropyltriethoxysilane, etc.).

D50 of the inorganic filler is preferably at most 20 $\mu$m and more preferably at most 10 $\mu$m. D50 is at least 0.01 $\mu$m and more preferably at least 0.1 $\mu$m.

The shape of the inorganic filler may be any of granular, needle (fibrous) or plate-like. Specific shapes of the inorganic filler include spherical, scaly, layered, leafy, apricot, columnar, chicken-crown, equiaxial, foliate, mica, blocky, flat, wedge-shaped, rosette-shaped, reticulate, and prismatic.

As the inorganic filler, one type may be used alone, or two or more types may be used in combination. When the present dispersion further contains an inorganic filler, its amount is preferably from 1 to 50 mass% and more preferably from 5 to 40 mass%, to the mass of the entire present dispersion.

Suitable specific examples of the inorganic filler include silica filler (such as the ADMAFINE (registered trademark) series manufactured by ADMATECHS COMPANY LIMITED), zinc oxide surface treated with an ester such as propylene glycol dicaprate (such as the FINEX (registered trademark) series manufactured by Sakai Chemical Industry Co., Ltd.), spherical fused silica filler (such as the SFP (registered trademark) series manufactured by Denka Company Limited), titanium dioxide filler coated with a polyhydric alcohol and an inorganic substance (such as the TIPAQUE (registered trademark) series manufactured by Ishihara Sangyo Kaisha, Ltd), rutile type titanium dioxide filler surface treated with an alkylsilane (such as JMT (registered trademark) series manufactured by TAYCA CORPORATION), hollow silica filler (such as E-SPHERES series manufactured by TAIHEIYO CEMENT CORPORATION, SiliNax series manufactured by Nittetsu Mining Co., Ltd., ECCOSPHERE series manufactured by Emerson & Cuming, etc.), talc filler (such as SG series manufactured by NIPPON TALC Co., Ltd.), steatite filler (such as BST series manufactured by Nippon Talc Co., Ltd.), boron nitride filler (such as UHP series manufactured by Showa Denko K.K., Denka Boron Nitride series ("GP" and "HGP" grades) manufactured by Denka Company Limited).

The present dispersion may contain, in addition to the above components, other components such as a thixotropic agent, a viscosity regulator, an antifoaming agent, a silane coupling agent, a dehydrating agent, a plasticizer, a weathering agent, an antioxidant, a heat stabilizer, a lubricant, an antistatic agent, a brightening agent, a colorant, a conductive agent, a mold release agent, a surface treatment agent, a flame retardant, a preservative, a fungicide, etc. to such an extent not to impair the effects of the present invention.

The preservative or the fungicide is preferably pyrolyzable, and a pyrolysis start temperature of from 125 to 200°C is more preferred. The temperature at which pyrolysis of the preservative or the fungicide begins is the temperature at which the rate of mass loss becomes to be at least 1 mass%/minute when the preservative or the fungicide (10 mg) is heated at a rate of 10°C/minute under a mixed gas (90% helium and 10% oxygen by volume) by using a thermogravimetric analyzer (TG) or thermogravimetric differential thermal analyzer (TG-DTA).

Further, as the preservative or the fungicide, a nonionic organic compound is preferred. Such a preservative can easily adhere to the surface of the powder particles due to its high interaction with the F polymer and surfactant, and can effectively enhance the antimicrobial effect. Further, since such a preservative is easily decomposed by heating when forming a molded product, it is less likely to remain in the obtainable molded product, thus preventing or inhibiting the degradation of the electrical properties (low dielectric constant, etc.) and heat resistance of the molded product.

Specific examples of the preservative or the fungicide include isothiazoline compounds, imidazole compounds, guanidine compounds, triazole compounds, benzothiazole compounds, nitroalcohol compounds, nitropropane compounds, dithiol compounds, thiophene compounds, dithiocarbamate compounds, phthalimide compounds, pyrithione compounds, phenylurea compounds, triazine compounds, thiazine compounds, quinolone compounds, 8-oxyquinoline compounds, pyridine oxide compounds, phenol compounds, anilide compounds, and adamantane compounds. Of these compounds, one type may be used alone or two or more types may be used in combination.

Among them, a preservative containing an isothiazoline compound is particularly suitably used. As commercially available products of such a preservative, "BIOHOPE" and "KB-838" manufactured by K.I Chemical Industry Co., Ltd. may be mentioned.

The viscosity of the present dispersion is preferably at least 10 mPa s and more preferably at least 50 mPa s. The viscosity of the present dispersion is preferably at most 10,000 mPa s and more preferably at most 1,000 mPa s.

The thixotropic ratio of the present dispersion is preferably at least 1.0. The thixotropic ratio of the present dispersion is preferably at most 3.0 and more preferably at most 2.0. Due to the above-described mechanism of action, the present dispersion can easily be prepared to have such a range of viscosity or thixotropic ratio, and is likely to be excellent in dispersion stability and handling efficiency.

The content of the F powder in the present dispersion is preferably at least 10 mass% and more preferably at least 25 mass% to the entire mass of the present dispersion. The content of the F powder is preferably at most 75 mass% and more preferably at most 60 mass% to the entire mass of the present dispersion.

The pH of the present dispersion is from 5 to 10 and preferably from 7 to 9. In such a case, the hue and long-term storage stability of the present dispersion are likely to be excellent.

In the present dispersion, it is preferred that the pH fluctuation range after storage at 25°C for 30 days be within ±1, and it is more preferred that the pH fluctuation range be within less than ±0.5.

Further, in the present dispersion, it is preferred that the viscosity of the dispersion after storage at 25°C for 30 days be at most 500 mPa·s, and it is more preferred that it be at most 100 mPa·s. Further, in a case where after the above storage, sedimentation is observed in the present dispersion, it means the viscosity measured after re-dispersion.

In the present dispersion, the dispersion ratio is preferably at least 60%, more preferably at least 70% and further preferably at least 80%. Here, the dispersion ratio is a value calculated by the following formula from the height of the entire dispersion in the screw tube and the height of the sedimentation layer (dispersion layer) after 14 days of standing at 25°C in a screw tube (30 mL in volume) of the present dispersion (18 mL). Here, if no sedimentation layer is observed after standing and there is no change in the state, the dispersion ratio is considered to be 100%, assuming that there is no change in the height of the entire dispersion.

$$\text{Dispersion ratio (\%) = (height of sedimentation layer)/(height of entire dispersion)} \times 100$$

The present dispersion is excellent in dispersion stability and long-term storage stability, and can form a molded product excellent in crack resistance and showing strong adhesion to a substrate. Further, the formed molded product has a low degree of coloration and is excellent in the hue.

The present dispersion may be applied to the surface of a substrate and heated to form a polymer layer containing the F polymer, to obtain a laminate having a substrate layer constituted by the substrate and a polymer layer. More specifically, the present dispersion may be applied to the surface of a substrate to form a liquid film, the liquid film is heated to remove the dispersant to form a dry film, and the dry film is further heated to sinter the F polymer, to obtain a laminate having a polymer layer containing the F polymer (hereinafter referred to also as the "F layer") on the surface of the substrate.

As the substrate, a metal substrate (such as a metal foil of copper, nickel, aluminum, titanium or an alloy thereof), a heat-resistant resin film (a film containing at least one type of heat-resistant resin, such as polyimide, polyarylate, polysulfone, polyarylsulfone, polyamide, polyetherimide, polyphenylene sulfide, polyaryl ether ketone, polyamideimide, liquid crystalline polyester, liquid crystalline polyesteramide, etc.), or a prepreg (a precursor of a fiber-reinforced resin substrate) may be mentioned.

The shape of the substrate may be planar, curved or uneven, and may also be any one of foil, plate, membrane or fiber.

As the method of applying the present dispersion to the surface of a substrate, any method may be employed so long as it is possible to form a stable liquid film (wet film) composed of the present dispersion on the surface of the substrate, and a coating method, a liquid spray method or an immersion method may be mentioned, and a coating method is preferred. By using the coating method, it is possible to efficiently form a liquid film on the surface of the substrate by a simple equipment.

As the coating method, a spray method, a roll coat method, a spin coat method, a gravure coat method, a micro-gravure coat method, a gravure offset method, a knife coat method, a kiss coat method, a bar coat method, a die coat method, a fountain-mayer bar method or a slot die coat method, may be mentioned.

When drying the liquid film, the liquid film is heated at a temperature at which the dispersant (water) volatilizes to form a dried film on the surface of the substrate. The temperature of heating in such drying is preferably from 100 to 200°C. Here, air may be blown in the process of removing the dispersant.

During the drying, the dispersant may not necessarily be completely volatilized, but may be volatilized only to such an extent that the layer shape after retention is stable and the freestanding film can be maintained.

When sintering the F polymer, it is preferred to heat the dried film at a temperature of at least the melting temperature of the F polymer. Such a heating temperature is preferably at most 380°C and more preferably at most 350°C.

As the respective heating methods, a method of using an oven, a method of using a draft-drying oven, and a method of irradiating heat rays such as infrared rays, may be mentioned. The heating may be conducted under either atmospheric pressure or reduced pressure. Further, the heating atmosphere may be any of an oxidizing gas atmosphere (such as oxygen gas), a reducing gas atmosphere (such as hydrogen gas), and an inert gas atmosphere (such as helium gas, neon gas, argon gas or nitrogen gas).

The heating time is preferably from 0.1 to 30 minutes and more preferably from 0.5 to 20 minutes.

When the heating is conducted under the above conditions, the F layer can be suitably formed while maintaining high productivity. Here, in a case where the present dispersion contains two types as the F polymer, i.e. particles of PTFE and particles of F polymer with a melting temperature of from 200 to 320°C (suitably a polymer containing TFE units and PAVE units and having oxygen-containing polar groups), the F layer will contain a fired product of PTFE and the F polymer with a melting temperature of from 200 to 320°C (suitably a polymer containing TFE units and PAVE units and having oxygen-containing polar groups).

The thickness of the F layer is preferably from 0.1 to 150 $\mu$m. Specifically, when the substrate layer is a metal foil, the thickness of the F layer is preferably from 1 to 30 $\mu$m. When the substrate layer is a heat-resistant resin film, the thickness of the F layer is preferably from 1 to 150 $\mu$m and more preferably from 10 to 50 $\mu$m.

The peel strength between the F layer and the substrate layer is preferably at least 10 N/cm and more preferably at least 15 N/cm. The above peel strength is preferably at most 100 N/cm. By using the present dispersion, such a laminate can be easily formed without damaging the physical properties of the F polymer in the F layer.

The present dispersion may be applied to only one surface of the substrate or to both surfaces of the substrate. In the former case, a laminate having a substrate layer composed of the substrate and an F layer on one surface of such a substrate layer, is obtainable, while in the latter case, a laminate having a substrate layer composed of the substrate and an F layer on both surfaces of such a substrate layer, is obtainable. The latter laminate is more resistant to warpage and thus has superior handling efficiency in its processing.

Specific examples of such a laminate include a metal-clad laminate having a metal foil and an F layer on at least one surface of the metal foil, and a multilayer film having a polyimide film and F layers on both surfaces of the polyimide film. These laminates are excellent in various properties such as electrical properties and thus suitable as printed circuit board materials, etc., and can be used for the production of flexible printed circuit boards or rigid printed circuit boards.

The laminate of the F layer and another substrate is useful as an antenna component, a printed circuit board, an aircraft component, an automotive component, a sports equipment, a food industrial good, a paint, a cosmetic, etc. In a printed circuit board, it can also be used as a new printed circuit board material to replace a conventional glass epoxy board to prevent temperature rise in a printed circuit board with densely mounted electronic components.

Further, it is useful also as an electric wire coating material (for aircraft wires, etc.), an enameled wire coating material for motors of electric vehicles, etc., an electrical insulation tape, an insulating tape for oil drilling, a printed circuit board material, a separation membrane (a microfiltration membrane, an ultrafiltration membrane, a reverse osmosis membrane, an ion exchange membrane, a dialysis membrane, a gas separation membrane, etc.), an electrode binder (for lithium secondary batteries, fuel cells, etc.), a copy roll, a furniture, an automotive dashboard, a cover for home appliances, etc., a sliding part (a load bearing, a sliding shaft, a valve, a bearing, a bushing, a seal, a thrust washer, a wear ring, a piston, a slide switch, a gear, a cam, a belt conveyor, a belt for food transport, etc.), a wear pad, a wear strip, a tube ramp, a test socket, a wafer guide, a centrifugal pump wear part, a hydrocarbon, chemical and water feed pump, a tool (a shovel, a rasper, a cutter, a saw, etc.), a boiler, a hopper, a pipe, an oven, a baking die, a chute, a die, a toilet bowl, a container-coating material, a power device, a transistor, a thyristor, a rectifier, a transformer, power MOS FET, CPU, a heat dissipating fin, and a metal heat sink.

Furthermore, it is useful as a PC or display housing, an electronic device material, an automobile interior or exterior, a processing equipment or vacuum oven for heat treating under a low-oxygen condition, a sealing material for e.g. a plasma treating device, and as a heat-dissipating component in processing units such as sputtering or various dry etching equipment.

When the present dispersion is impregnated into woven fabric and dried by heating, an impregnated woven fabric (the present woven fabric) having the F polymer impregnated into the woven fabric, is obtainable. The present woven fabric can be said to be a coated woven fabric in which the woven fabric is coated with an F layer.

As the woven fabric, a glass fiber woven fabric, a carbon fiber woven fabric, an aramid fiber woven fabric or a metal fiber woven fabric is preferred, and a glass fiber woven fabric or a carbon fiber woven fabric is more preferred. The woven fabric may be treated with a silane coupling agent from the viewpoint of enhancing adhesive bonding with the F layer.

The total content of the F polymer in the present woven fabric is preferably from 30 to 80 mass%.

As the method for impregnating a woven fabric with the present dispersion, a method of immersing the woven fabric in the present dispersion, or a method of applying the present dispersion to the woven fabric, may be mentioned.

When drying the woven fabric impregnated with the present dispersion, the F polymer may be fired. As the method for firing the F polymer, a method of passing the woven fabric through a ventilated drying oven in an atmosphere of from 300 to 400°C. Here, the drying of the woven fabric and the firing of the F polymer may be carried out in one step.

This woven fabric is excellent in properties such as high adhesion (bonding) between the F layer and the woven fabric, high surface smoothness and low distortion. By thermo-compression bonding such present woven fabric and a metal foil, a metal-clad laminate with high peel strength and low warpage can be obtained, whereby it can be suitably used as a printed circuit board material.

Further, in the production of the present woven fabric, the woven fabric impregnated with the present dispersion may be applied to the surface of the substrate, heated and dried to form an impregnated woven fabric layer containing the F polymer and the woven fabric, thereby to produce a laminate in which the substrate and the impregnated woven fabric layer are laminated in this order. The method is not particularly limited, and by applying the woven fabric impregnated with the present dispersion to part or all of the inner wall surface of a member such as a tank, pipe or container, and heating the above member while rotating the member, the impregnated woven fabric layer can be formed on part or all of the inner wall surface of the member. This production method is also useful as a lining method for the inner wall surface of a member such as a tank, pipe or container.

The present dispersion is excellent in dispersion stability and can be highly impregnated in a porous or fibrous material, as described above in the mechanism of action.

As such a porous or fibrous material, a material other than the above-described woven fabric, specifically, a plate, columnar or fibrous material, may be mentioned. These materials may be pretreated with a curing resin, a silane coupling agent, etc., and may be further filled with an inorganic filler, etc. Further, these materials may also be twisted together to form a yarn, a cable or a wire. At the time of the twisting, an intervening layer made of another polymer such as polyethylene may be placed.

As an embodiment to produce a molded product by impregnating such a material with the present dispersion, an embodiment to impregnate a fibrous material loaded with a curable resin or cured material with the present dispersion, may be mentioned.

As the fibrous material, a high-strength and low-elongation fiber such as carbon fiber, aramid fiber, glass fiber or silicon carbide fiber may be mentioned.

As the curable resin, a thermocurable resin such as an epoxy resin, an unsaturated polyester resin or a polyurethane resin is preferred.

As a specific example of such an embodiment, a composite cable formed by impregnating a cable made of twisted carbon fibers loaded with a thermosetting resin with the present dispersion and further heating to fire the F polymer, may be mentioned. Such a composite cable is useful as a cable for a large structure, a ground anchor, an oil drilling, a crane, a cableway, an elevator, agriculture, forestry, fishing or a sling cable.

In the foregoing, the present dispersion has been described, but the present invention is not limited to the construction of the aforementioned embodiments. For example, the present dispersion may have any other optional construction added to the construction of the above embodiments, or may be substituted with any other optional construction which exhibits the same function.

EXAMPLES

In the following, the present invention will be described in detail with reference to Examples, but the present invention is not limited to these Examples.

1. Details of the respective components

[F powder]

F powder 1: Powder (D50: 2.1 μm) consisting of a polymer (melt temperature: 300°C) containing TFE units, NAH units and PPVE units in this order in amounts of 97.9 mol%, 0.1 mol% and 2.0 mol% and having 1,000 carbonyl group-containing groups per $1 \times 10^6$ carbon atoms of the main chain.

[Buffer]

Buffer 1: A pH buffer liquid prepared by mixing a tris(hydroxymethyl)aminomethane aqueous solution and hydrochloric acid to adjust the pH to be 8.0.

Buffer 2: A pH buffer liquid prepared by mixing ammonium bicarbonate, water and ammonia water to adjust the pH to be 8.0

Buffer 3: A pH buffer liquid prepared by mixing sodium dihydrogen phosphate hydrate and water to adjust the pH to be 8.0

Buffer 4: A pH buffer liquid prepared by mixing sodium bicarbonate, sodium carbonate and water to adjust the pH to be 8.0

[Surfactant]

Surfactant 1: Polyoxyalkylene-modified polydimethylsiloxane having dimethylsiloxane units in the main chain and oxyethylene groups at the terminal of the main chain or in side chains

Surfactant 2: Polyethylene glycol trimethyl nonyl ether

2-1. Production of dispersion

[Ex. 1]

Into a pot, F powder 1, buffer 1, surfactant 1 and water were added, and zirconia balls were added. Then, the pot was rolled at 150 rpm for 1 hour to obtain dispersion 1 containing F powder 1 (40 mass parts), buffer 1 (0.2 mass part), surfactant 1 (4 mass parts), surfactant 2 (4 mass parts) and water (51.8 mass parts). The viscosity of the obtained dispersion 1 was 20 mPa s, and the pH of dispersion 1 immediately after preparation was 8.0. The concentration of tris(hydroxymethyl)aminomethane and its salt in dispersion 1 corresponds to 0.02 mol/L.

[Ex. 2]

Into a pot, F powder 1, buffer 2, surfactant 1 and water were added, and zirconia balls were added. Then, the pot was rolled at 150 rpm for 1 hour to obtain dispersion 2 containing F powder 1 (40 mass parts), buffer 2 (0.2 mass part), surfactant 1 (4 mass parts), surfactant 2 (4 mass parts) and water (51.8 mass parts). The viscosity of the obtained dispersion 2 was 20 mPa s, and the pH of dispersion 2 immediately after preparation was 8.0. The concentration of ammonium bicarbonate and ammonium hydroxide in dispersion 2 corresponds to 0.02 mol/L.

[Ex. 3]

Dispersion 3 was obtained in the same manner as in Ex. 1, except that buffer 1 was changed to buffer 3. The pH of dispersion 3 immediately after preparation was 8.0.

[Ex. 4]

Dispersion 4 was obtained in the same manner as in Ex. 1, except that buffer 1 was changed to buffer 4. The pH of dispersion 4 immediately after preparation was 8.0.

[Ex. 5]

Into a pot, F powder 1, surfactant 1, triethanolamine and water were added, and zirconia balls were added. Then, the pot was rolled at 150 rpm for 1 hour to obtain dispersion 5 containing powder 1 (40 mass parts), triethanolamine (1.5 mass parts), surfactant 1 (4 mass parts) and water (54.5 mass parts). The viscosity of the obtained dispersion 5 was 20 mPa·s, and the pH of dispersion 5 immediately after preparation was 9.2.

2-2. Evaluation of dispersion

Each dispersion was filled into a 70 mL vial (inner volume: 100 mL), sealed and left to stand still to be stored at 25°C for 30 days. The pH stability, the redispersibility and thickening properties, and hue stability of the dispersion were evaluated in accordance with the following standards. The evaluation results are summarized in Table 1.

[Evaluating standards for pH stability]

○: The range of pH fluctuation before and after storage is less than ±0.5.
△: The range of pH fluctuation before and after storage is at least ±0.5 and less than 1.0.
×: The range of pH fluctuation before and after storage is at least ±1.0.

[Evaluation standards for redispersibility and thickening]

○: The dispersion can be easily redispersed after storage, and the viscosity of the dispersion after redispersion is at most 100 mPa s.
×: The dispersion can be redispersed after storage, but the viscosity of the dispersion after redispersion is at least 100 mPas and is significantly thickened.

[Evaluation standards for hue stability]

○: The change in hue of the dispersion before and after storage is little.
△: The change in the hue of the dispersion before and after storage is observed.
×: The change in the hue of the dispersion before and after storage is remarkable.

[Table 1]

|  | Dispersion 1 | Dispersion 2 | Dispersion 3 | Dispersion 4 | Dispersion 5 |
|---|---|---|---|---|---|
| pH Stability | ○ | ○ | ○ | △ | × |
| Redispersibility and thickening properties | ○ | ○ | × | × | × |
| Hue stability | ○ | ○ | △ | × | × |

3-1. Production of laminate

Dispersion 1 was applied to the surface of a long copper foil (thickness: 18 μm) by using a bar coater to form a wet film. Then, the metal foil having this wet film formed was passed through a drying oven at 120°C for 5 minutes to dry it by heating to obtain a dry film. Then, the dry film was heated in a nitrogen oven at 380°C for 3 minutes. This produced a laminate 1 having a metal foil and a polymer layer (thickness: 5 μm) as a molded product, containing a melt-fired product of the F powder 1, on its surface.

Laminates 2 to 5 were produced in the same manner as the laminate 1, except that dispersion 1 was changed to dispersions 2 to 5.

3-2. Evaluation of laminates

The surface of the polymer layer of each laminate was visually inspected, whereby the surface smoothness and hue were evaluated in accordance with the following standards. The evaluation results are summarized in Table 2.

[Evaluation standards for surface smoothness]

○: The surface is smooth.
×: The surface has holes and is not smooth.

[Evaluation standards for hue]

○: No coloration is observed.
△: Coloration is slightly observed.
×: Coloration is remarkably observed.

[Table 2]

|  | Laminate 1 | Laminate 2 | Laminate 3 | Laminate 4 | Laminate 5 |
|---|---|---|---|---|---|
| Surface smoothness | ○ | ○ | × | × | ○ |
| Hue | △ | ○ | - | - | × |

[Transparency]

The copper foils of laminate 1, laminate 2, and laminate 5 were removed by etching with a ferric chloride aqueous solution to obtain single polymer layers. The hazes of the polymer layers were measured in accordance with JIS K 7136. The hazes of the polymer layers of the respective laminates were smaller in the order of laminate 2, laminate 1, and laminate 5. That is, the transparency of the polymer layer of laminate 2 was the highest.

Further, the aqueous dispersion obtained by using a pH buffer liquid having the pH adjusted to be 9.0 in the same manner as buffer 2, except for changing the mixing ratio of ammonium bicarbonate, water and ammonia water, also exhibited pH stability, redispersibility and hue stability comparable to dispersion 2.

INDUSTRIAL APPLICABILITY

The aqueous dispersion of the present invention can be used for an application of impregnating and drying the insulation layer of printed circuit boards, thermal interface materials, substrates for power modules, and coils to be used in power devices such as motors, to form a thermally conductive heat-resistant coating layer, for an application of bonding ceramic parts and metal parts to one another in automotive engines, for an application of providing corrosion resistance to heat exchangers and their constituent fins or tubes, and for an application of coating the inside and outside of glass containers. It is particularly suitable for coating to provide impact resistance. Here, the glass containers include vials, syringes, syringes with needles and cartridge-type syringes, and ampoules.

The aqueous dispersion of the present invention is also used as a binder material for electrodes, a coating material for separators, and a coating material for electrodes (positive and negative electrodes) to be used in electrochemical devices equipped with electrodes, such as secondary batteries such as lithium ion batteries, primary batteries such as lithium batteries, radical batteries, solar cells (especially dye-sensitized solar cells), fuel cells, lithium ion capacitors, hybrid capacitors, capacitors (such as electric double layer capacitors), various capacitors (such as aluminum electrolytic capacitors, tantalum electrolytic capacitors), electrochromic devices, electrochemical switching devices, and various electrochemical sensors.

Further, the aqueous dispersion of the present invention containing also a conductive filler, is also suitable for use in applications where conductivity is required, for example, in the field of printed electronics. Specifically, it can be used in the production of current-carrying elements in printed circuit boards, sensor electrodes, displays, backplanes, RFID (radio frequency identification), solar power generation, lighting, disposable electronic devices, automotive heaters, electromagnetic interference (EMI) shielding, membrane switches, etc.

Further, the molded product obtained from the aqueous dispersion of the present invention can be used as an adhesive for bonding electronic components such as IC chips, resistors, and capacitors to be mounted on boards in semiconductor devices, high-density boards, and module components, as well as for bonding circuit boards and heat sinks, and for bonding LED chips to boards. Furthermore, the aforementioned molded product can also be used as a conductive bonding material between circuit wiring and electronic components in the mounting process of electronic components (for an application as an alternative to solder bonding). In addition, it can be used as an adhesive between ceramic parts or metal parts to one another in vehicle engines. And the aforementioned molded product can also be used for the applications described in paragraph number [0149] of WO2016/017801.

**Claims**

1. An aqueous dispersion containing particles of a tetrafluoroethylene-type polymer, at least one compound selected from the following groups of compounds (1), (2) and (3), and water, with a pH of at least 5 and at most 10:

   (1) 2-morpholinoethanesulfonic acid, bis(2-hydroxyethyl)iminotris(hydroxymethyl)methane, N-(2-acetamido)-2-aminoethanesulfonic acid, 2-hydroxy-3-morpholinopropanesulfonic acid, 2-hydroxy-N-tris(hydroxymethyl)methyl-3-aminopropanoic acid, N-tris(hydroxymethyl)methyl-3-aminopropanoic acid, N,N-bis(2-hydroxyethyl)-2-aminoethanesulfonic acid, 3-morpholinopropanesulfonic acid, N-tris(hydroxymethyl)methyl-2-aminoethanesulfonic acid, 4-(2-hydroxyethyl)-1-piperazine ethanesulfonic acid, 4-(2-hydroxyethyl)-1-piperazine propanesulfonic acid, N-[tris(hydroxymethyl)methyl]glycine, tris(hydroxymethyl)aminomethane, N,N-bis(2-hydroxyethyl)glycine, glycylglycine, N-cyclohexyl-2-aminoethanesulfonic acid, N-cyclohexyl-3-aminopropanesulfonic acid and ethylenediaminetetraacetic acid,
   (2) salts of the compounds in the above (1),
   (3) an ammonium salt of any of the following acids: carbonic acid, phosphoric acid, boric acid, formic acid, oxalic acid, acetic acid, citric acid and lactic acid

2. The aqueous dispersion according to Claim 1, wherein the tetrafluoroethylene-type polymer is a tetrafluoroethylene-type polymer with a fluorine atom content of at least 70 mass% and a melting temperature of from 200 to 320°C.

3. The aqueous dispersion according to Claim 1 or 2, wherein the tetrafluoroethylene-type polymer is a tetrafluoroethylene-type polymer which contains units based on a perfluoro(alkyl vinyl ether) and which has oxygen-containing polar groups.

4. The aqueous dispersion according to any one of Claims 1 to 3, wherein the average particle diameter (cumulative 50% diameter on a volume basis) of the particles of the tetrafluoroethylene-type polymer is from 0.1 to 25 $\mu$m.

5. The aqueous dispersion according to any one of Claims 1 to 4, wherein the particles of the tetrafluoroethylene-type polymer include particles of polytetrafluoroethylene and particles of a tetrafluoroethylene-type polymer with a melting temperature of from 200 to 320°C.

6. The aqueous dispersion according to any one of Claims 1 to 5, which further contains a nonionic surfactant.

7. The aqueous dispersion according to Claim 6, wherein the nonionic surfactant is a polyoxyalkylene-modified polydimethylsiloxane having a weight average molecular weight of at most 3000 and an HLB value calculated from the Griffin formula of from 1 to 18.

8. The aqueous dispersion according to any one of Claims 1 to 7, wherein the content of the at least one compound is from 0.01 to 5 mass% to the total mass of the aqueous dispersion.

9. The aqueous dispersion according to any one of Claims 1 to 8, wherein the salts of the compounds in the above (1) are in the form of hydrochloric acid salts, ammonium salts or organic acid salts.

10. The aqueous dispersion according to any one of Claims 1 to 9, wherein the at least one compound is an ammonium salt of a compound selected from the group consisting of carbonic acid, phosphoric acid, boric acid, formic acid, oxalic acid, acetic acid, citric acid and lactic acid.

11. The aqueous dispersion according to Claim 10, wherein the at least one compound is ammonium formate, ammonium oxalate, ammonium acetate, triammonium citrate, diammonium hydrogen phosphate, triammonium phosphate, ammonium borate, ammonium hydrogen carbonate, or ammonium carbonate.

12. The aqueous dispersion according to any one of Claims 1 to 11, wherein the at least one compound is ammonium bicarbonate, ammonium carbonate or ammonium acetate.

13. The aqueous dispersion according to any one of Claims 1 to 12, wherein the range of pH fluctuation after storage at 25°C for 30 days is within ±1.

14. A method for producing a laminate, which comprises applying the aqueous dispersion as defined in any one of Claims 1 to 13 to the surface of a substrate, followed by heating to form a polymer layer containing the tetrafluoroethylene-type polymer, to obtain a laminate having a substrate layer consisting of the substrate and the polymer layer.

15. A method for producing an impregnated woven fabric, which comprises impregnating the aqueous dispersion as defined in any one of Claims 1 to 13 to a woven fabric, followed by heating to obtain an impregnated woven fabric containing the tetrafluoroethylene-type polymer.

## INTERNATIONAL SEARCH REPORT

| International application No. |
|---|
| **PCT/JP2021/046711** |

**A. CLASSIFICATION OF SUBJECT MATTER**

***B05D 7/24***(2006.01)i; ***B32B 27/18***(2006.01)i; ***B32B 27/30***(2006.01)i; ***C08K 5/16***(2006.01)i; ***C08K 5/42***(2006.01)i;
***C08L 27/18***(2006.01)i; ***C08K 3/28***(2006.01)i; ***D06M 13/256***(2006.01)i; ***D06M 15/256***(2006.01)i
FI: C08L27/18; C08K5/16; C08K5/42; C08K3/28; D06M15/256; D06M13/256; B05D7/24 302L; B05D7/24 301G;
B05D7/24 303Z; B32B27/30 D; B32B27/18 Z

According to International Patent Classification (IPC) or to both national classification and IPC

**B. FIELDS SEARCHED**

Minimum documentation searched (classification system followed by classification symbols)

C08L; C08K5/16; C08K5/42; C08K3/28; D06M 13/256; D06M 15/256

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| Y | JP 2006-299267 A (SOLVAY SOLEXIS SPA) 02 November 2006 (2006-11-02) claims, paragraphs [0036], [0043], [0052] | 1-6, 8, 9, 13-15 |
| A | | 7 |
| Y | JP 2015-71700 A (SEIKO EPSON CORP.) 16 April 2015 (2015-04-16) paragraph [0061] | 1-6, 8, 9, 13-15 |
| A | | 7 |
| A | WO 2020/004339 A1 (AGC INC.) 02 January 2020 (2020-01-02) entire text | 1-9, 13-15 |
| A | JP 2012-214766 A (DAIKIN INDUSTRIES., LTD.) 08 November 2012 (2012-11-08) claims, example 6 | 1-9, 13-15 |
| A | JP 2019-52211 A (MITSUBISHI PENCIL CO., LTD.) 04 April 2019 (2019-04-04) claims, example 8 | 1-9, 13-15 |

✓ Further documents are listed in the continuation of Box C.      ✓ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **01 March 2022** | **08 March 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

International application No.

**PCT/JP2021/046711**

### C.    DOCUMENTS CONSIDERED TO BE RELEVANT

| Category* | Citation of document, with indication, where appropriate, of the relevant passages | Relevant to claim No. |
|---|---|---|
| A | JP 2006-188704 A (SOLVAY SOLEXIS SPA) 20 July 2006 (2006-07-20) <br> claims, examples 4-6, 7-9 | 1-9, 13-15 |
| A | JP 2005-162994 A (DAIKIN IND., LTD.) 23 June 2005 (2005-06-23) <br> entire text | 1-9, 13-15 |
| A | JP 8-48932 A (DAIKIN IND., LTD.) 20 February 1996 (1996-02-20) <br> entire text | 1-9, 13-15 |
| A | JP 5-271359 A (JAPAN SYNTHETIC RUBBER CO., LTD.) 19 October 1993 (1993-10-19) <br> entire text | 1-9, 13-15 |
| A | JP 2005-248157 A (DAIKIN IND., LTD.) 15 September 2005 (2005-09-15) <br> claims, paragraph [0075] | 1-9, 13-15 |

Form PCT/ISA/210 (second sheet) (January 2015)

## INTERNATIONAL SEARCH REPORT

| International application No. |
| --- |
| **PCT/JP2021/046711** |

**Box No. III        Observations where unity of invention is lacking (Continuation of item 3 of first sheet)**

This International Searching Authority found multiple inventions in this international application, as follows:

The invention as in claims 1-15 include the seven invention groups below.

Invention group 1: Among claims 1-9 and 13-15, the invention having, as a compound, any one of 2-morpholinoethanesulfonic acid, bis(2-hydroxyethyl)iminotris(hydroxymethyl)methane, N-(2-acetamido)-2-aminoethanesulfonic acid, 2-hydroxy-3-morpholinopropane sulfonic acid, N,N-bis(2-hydroxyethyl)-2-aminoethanesulfonic acid, 3-morpholinopropanesulfonic acid, N-tris(hydroxymethyl)methyl-2-aminoethanesulfonic acid, 4-(2-hydroxyethyl)-1-piperazinethanesulfonic acid, 4-(2-hydroxyethyl)-1-piperazinethanesulfonic acid, N-cyclohexyl-2-aminoethanesulfonic acid, N-cyclohexyl-3-aminopropanesulfonic acid, and salts of these compounds.

Invention group 2: Among claims 1-9 and 13-15, the invention having, as a compound, any one of 2-hydroxy-N-tris(hydroxymethyl)methyl-3-aminopropanoic acid, N-tris(hydroxymethyl)methyl-3-aminopropanoic acid, tris(hydroxymethyl)aminomethane, and salts of these compounds.

Invention group 3: Among claims 1-9 and 13-15, the invention having, as a compound, any one of N-[tris(hydroxymethyl)methyl]glycine and a salt of this compound.

Invention group 4: Among claims 1-9 and 13-15, the invention having, as a compound, any one of N,N-bis(2-hydroxyethyl)glycine and a salt of this compound.

Invention group 5: Among claims 1-9 and 13-15, the invention having, as a compound, any one of glycylglycine and a salt of this compound.

Invention group 6: Among claims 1-9 and 13-15, the invention having, as a compound, any one of ethylenediaminetetraacetic acid and a salt of this compound.

Invention group 7: Among claims 1-8 and 10-15, the invention having an ammonium salt of an acid of any one of carbonic acid, phosphoric acid, boric acid, formic acid, oxalic acid, acetic acid, citric acid, and lactic acid.

The feature shared by any two invention groups of invention group 1 to invension group 7 above is "an aqueous dispersion containing tetrafluoroethylene-based polymer particles, a nitrogen-containing compound, and water, wherein the pH is 5-10." However, this shared feature is disclosed in documents 1-7 and cannot be said to be a special technical feature.
    Furthermore, the feature shared by each of invention groups 3-5 above is "an aqueous dispersion containing tetrafluoroethylene-based polymer particles, a compound having a glycerin structure, and water, wherein the pH is 5-10." However, this shared feature is disclosed in document 2 and cannot be said to be a special technical feature.
    Accordingly, invention groups 1-7 lack unity of invention.

1. WO 2020/004339 A1 (claims, paragraph [0046])
2. JP 2012-214766 A (claims, example 6)
3. JP 2019-52211 A (claims, example 8)
4. JP 2006-188704 A (claims, examples 4-6, 7-9)
5. JP 2005-162994 A (claims, paragraphs [0069], [0080], examples)
6. JP 8-48932 A (claims, examples)
7. JP 5-230312 A (claims, examples)

Form PCT/ISA/210 (continuation of first sheet) (January 2015)

## INTERNATIONAL SEARCH REPORT

| International application No. |
| --- |
| **PCT/JP2021/046711** |

**Box No. III    Observations where unity of invention is lacking (Continuation of item 3 of first sheet)**

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☑ No required additional search fees were timely paid by the applicant. Consequently, this international search report is restricted to the invention first mentioned in the claims; it is covered by claims Nos.: **Some of claims 1-9, 13-15 (said invention group 1)**

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (January 2015)

## INTERNATIONAL SEARCH REPORT
### Information on patent family members

International application No.

**PCT/JP2021/046711**

| Patent document cited in search report | | | Publication date (day/month/year) | Patent family member(s) | | Publication date (day/month/year) |
|---|---|---|---|---|---|---|
| JP | 2006-299267 | A | 02 November 2006 | US 2006/0247366 A1 claims, paragraphs [0064], [0075], [0107]-[0117] EP 1714986 A1 CN 1880347 A | | |
| JP | 2015-71700 | A | 16 April 2015 | US 2015/0096466 A1 paragraph [0065] | | |
| WO | 2020/004339 | A1 | 02 January 2020 | US 2021/0024702 A1 whole document EP 3816226 A1 CN 112334534 A KR 10-2021-0024996 A TW 202000804 A | | |
| JP | 2012-214766 | A | 08 November 2012 | US 9080035 B2 claims, example 6 WO 2012/133655 A1 CN 103443196 A | | |
| JP | 2019-52211 | A | 04 April 2019 | (Family: none) | | |
| JP | 2006-188704 | A | 20 July 2006 | US 2006/0144794 A1 claims, examples 4-6, 7-9 EP 1676867 A1 CN 1827655 A | | |
| JP | 2005-162994 | A | 23 June 2005 | (Family: none) | | |
| JP | 8-48932 | A | 20 February 1996 | US 5750606 A whole document EP 774498 A1 CN 1155289 A TW 309532 B KR 10-1997-0704846 A | | |
| JP | 5-271359 | A | 19 October 1993 | (Family: none) | | |
| JP | 2005-248157 | A | 15 September 2005 | TW 200528477 A CN 1637087 A | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019052211 A
- JP 2019182956 A
- JP 2012214766 A
- WO 2020145133 A
- WO 201816644 A
- WO 2016017801 A